# EUROPEAN PATENT APPLICATION

(11) **EP 1 592 265 A1**
(43) Date of publication of application: **02.11.2005**
(21) Application number: 04010172.7
(22) Date of filing: 29.04.2004
(51) Int. Cl.: H04Q 1/14, H05K 5/00

(54) **Modular signal splitter for voice/data signal separation**

(71) Applicant: YCL ELECTRONICS CO., LTD., Feng Shan City, Kaohsiung County (TW)
(72) Inventor: Hsieh, Ping-Hui, Chiao Tou Hsiang Kaohsiung County (TW); Tsai, Tsung-Chih, Ku Shan District Kaohsiung City (TW)
(74) Representative: Kahlhöfer, Hermann

(57) **Abstract**

A modular signal splitter (3) is adapted to separate a voice signal from a data signal in a telephone exchange (2). The telephone exchange (2) includes a switchboard (20) that is provided with a socket (21) coupled to a telephone netwoek. The modular signal splitter (3) includes a casing (30) confining a receiving space (301) and formed with a mounting hole (36) therethrough. A filter circuit (4) has a circuit portion (41) that is disposed in the receiving space (301), and a terminal portion (42) that extends outwardly of the casing (30) through the mounting hole (36) and that is adapted to be inserted removably into the socket (21) in the switchboard (20) of the telephone exchange (2).

## Description

The invention relates to a signal splitter, more particularly to a modular signal splitter that is capable of being inserted into a socket in a telephone exchange to separate a voice signal from a data signal.

In an ADSL (Asymmetric Digital Subscriber Line) system, telephony and data signals can be transferred at the same time on a common telephone line.

In traditional ADSL technology, a conventional splitter filter is applied to a telephone exchange for separating a voice signal from a data signal in the telephone exchange. To couple the conventional splitter filter to the telephone exchange, a multi-port connector, such as an 8-port connector or a 12-port connector, is required, thereby resulting in increased costs. Due to the presence of the multi-port connector, the conventional splitter filter is provided for multi-subscriber applications. As such, when it is desired to repair or replace the multi-port connector or the conventional splitter filter as a result of damage or breakdown, multi-subscriber interruption occurs.

Therefore, the object of the present invention is to provide a modular signal splitter that can eliminate the aforesaid drawbacks of the prior art.

According to the present invention, there is provided a modular signal splitter adapted to separate a voice signal from a data signal in a telephone exchange. The telephone exchange includes a switchboard that is provided with a socket coupled to a telephone network. The modular signal splitter comprises:
a casing confining a receiving space and formed with a mounting hole therethrough; and
a filter circuit having a circuit portion that is disposed in the receiving space, and a terminal portion that extends outwardly of the casing through the mounting hole and that is adapted to be inserted removably into the socket in the switchboard of the telephone exchange.

Other features and advantages of the present invention will become apparent in the following detailed description of the preferred embodiments with reference to the accompanying drawings, of which:
Figure 1 is a fragmentary perspective view showing a telephone exchange together with the first preferred embodiment of a modular signal splitter according to the present invention;
Figure 2 is a perspective view showing the first preferred embodiment;
Figure 3 is an exploded perspective view showing the first preferred embodiment;
Figure 4 is a schematic side view showing the first preferred embodiment with a casing part thereof removed;
Figure 5 is a fragmentary perspective view showing a telephone exchange together with a test probe, and the second preferred embodiment of a modular signal splitter according to the present invention;
Figure 6 is a schematic side view showing the second preferred embodiment with a casing part thereof removed;
Figure 7 is a fragmentary perspective view showing a telephone exchange together with a test probe, and the third preferred embodiment of a modular signal splitter according to the present invention; and
Figure 8 is a schematic side view showing the third preferred embodiment.with a casing part thereof removed.

Before the present invention is described in greater detail, it should be noted that like elements are denoted by the same reference numerals throughout the disclosure.

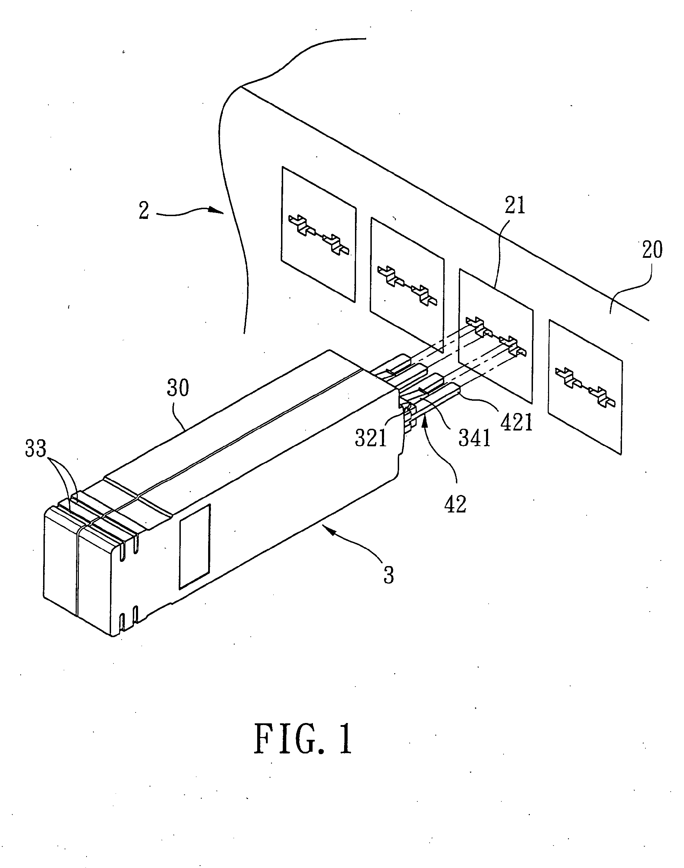

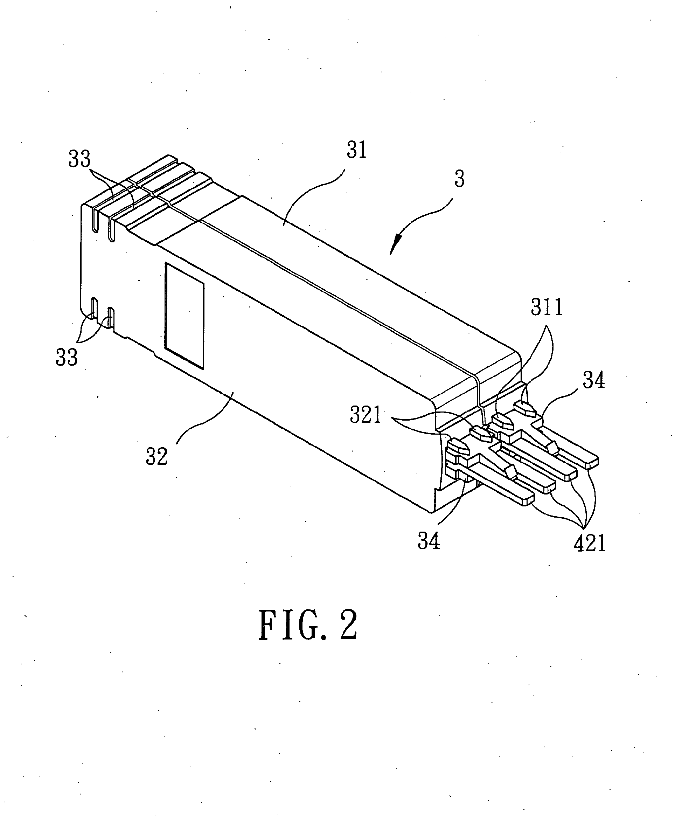

Referring to Figures 1 to 3, according to the first preferred embodiment of the present invention, a modular signal splitter 3 is adapted to separate a voice signal from a data signal in a telephone exchange 2. In this embodiment, the telephone exchange 2 includes a switchboard 20 that is provided with a plurality of sockets 21, each of which is coupled to a telephone network (not shown). In other words, each of the sockets 21 serves as a port for a single subscriber. The modular signal splitter 3 includes a casing 30 and a filter circuit 4.

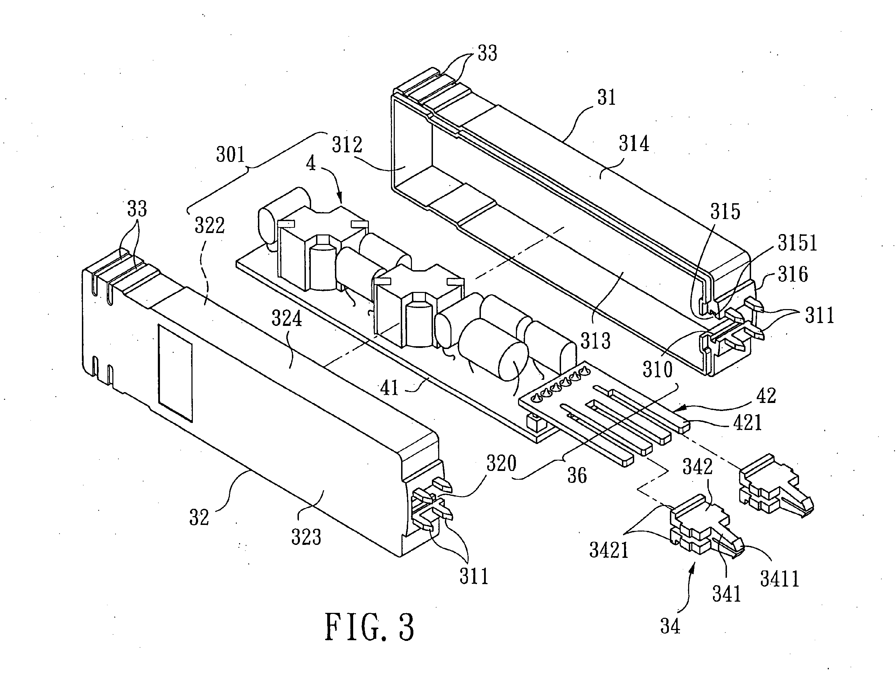

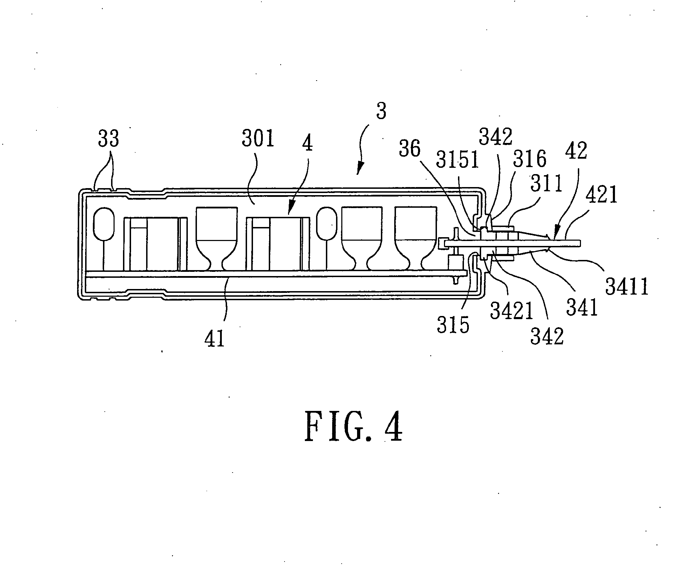

The casing 30 confines a receiving space 301, and is formed with a mounting hole 36 therethrough, as best shown in Figure 4. In this embodiment, as shown in Figure 3, the casing 30 includes complementary casing parts 31, 32, each of which is formed with a groove 312, 322. The receiving space 301 is defined by the grooves 312, 322 in the casing parts 31, 32. Each of the casing parts 31, 32 has a base wall 313, 323, and a surrounding wall 314, 324 that extends from a periphery of the base wall 313, 323, that cooperates with the base wall 313, 323 to define the groove 312, 323, and that is formed with a notch 310, 320. The mounting hole 36 is defined by the notches 310, 320 in the surrounding walls 31, 324 of the casing parts 31, 32. In this embodiment, the surrounding wall 314, 324 of each casing part 31, 32 has an outer surface formed with a plurality of anti-slip treads 33.

The filter circuit 4 has a circuit portion 41 that is disposed in the receiving space 301, and a terminal portion 42 that extends outwardly of the casing 30 through the mounting hole 36 and that is adapted to be inserted removably into a corresponding one of the sockets 21 in the switchboard 20 of the telephone exchange 2, as best shown in Figure 4. The circuit portion 41 includes electronic elements for low-pass filtering purposes such that the low-frequency voice signal can be split from the data signal in the telephone exchange 2 in a known manner. In this embodiment, the terminal portion 42 includes four terminals 421.

It is noted that the modular signal splitter 3 further includes a fastener unit for fastening releasably the casing 30 on the switchboard 20 of the telephone exchange 2 when the terminal portion 42 of the filter circuit 4 is inserted into the corresponding one of the sockets 21 in the switchboard 20 of the telephone exchange 2. In this embodiment, the fastener unit includes a pair of fastener members 34, each of which is sleeved through the terminal portion 42 of the filter circuit 4, and has a securing portion 342 coupled to the casing 30, and a fastening portion 341 opposite to the securing portion 342. In this embodiment, the fastening portion 341 of each fastener member 34 is formed with a hook 3411 that is adapted to engage a corresponding engaging slot in the corresponding socket 21 when the terminal portion 42 of the filter circuit 4 is inserted into the corresponding one of the sockets 21 in the switchboard 20 of the telephone exchange 2, as shown in Figure 1. Furthermore, the mounting hole 36 in the casing 30 is defined by a hole-defining wall 315 formed with an engaging recess 3151. The securing portion 342 of each fastener member 34 is formed with an engaging flange 3421 to engage the engaging recess 3151, as best shown in Figure 4. The mounting hole 36 in the casing 30 is further defined by a peripheral wall 316 formed with support posts 311. The support posts 311 abut against the fastener members 34 so as to limit movement of the fastener members 34 relative to the casing 30.

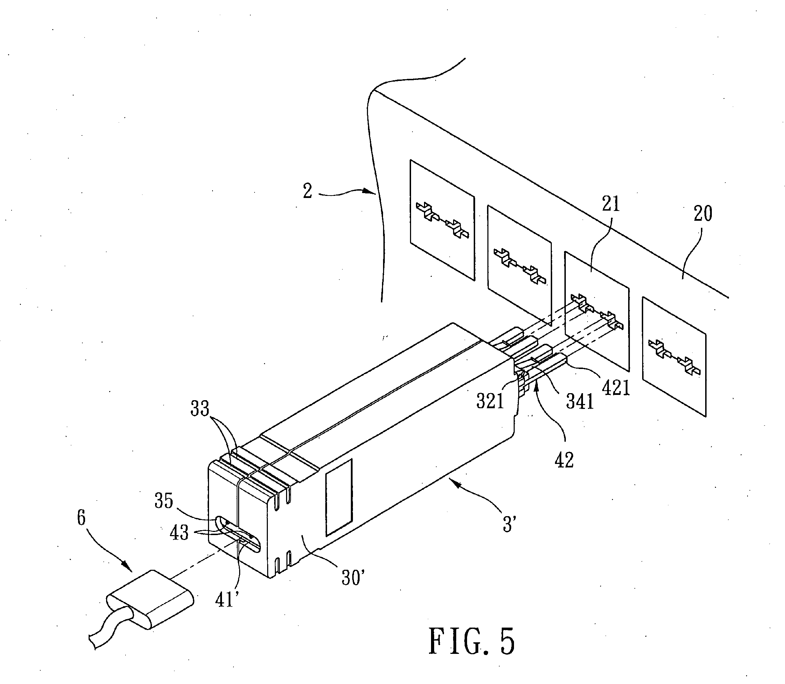

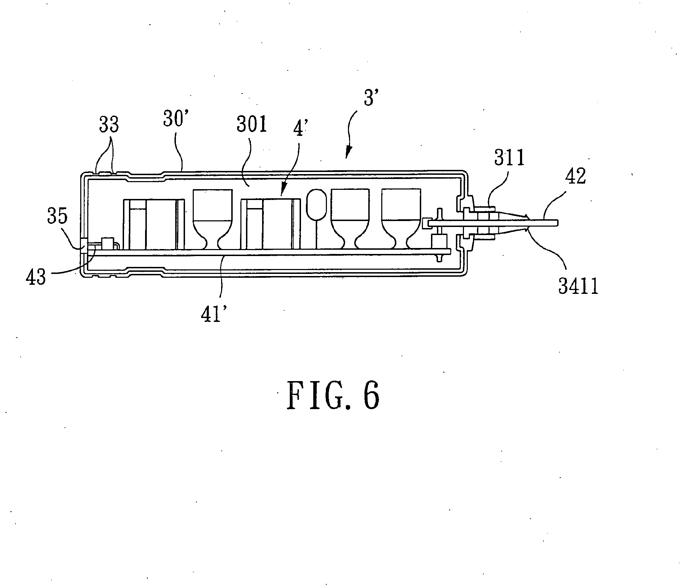

Figures 5 and 6 illustrate the second preferred embodiment of a modular signal splitter 3' according to this invention, which is a modification of the first preferred embodiment. In this embodiment, the circuit portion 41' of the filter circuit 4' is provided with a set of test pins 43. The casing 30' is formed with a slot 35 that is adapted for receiving a test probe 6 of a test equipment to contact the test pins 43.

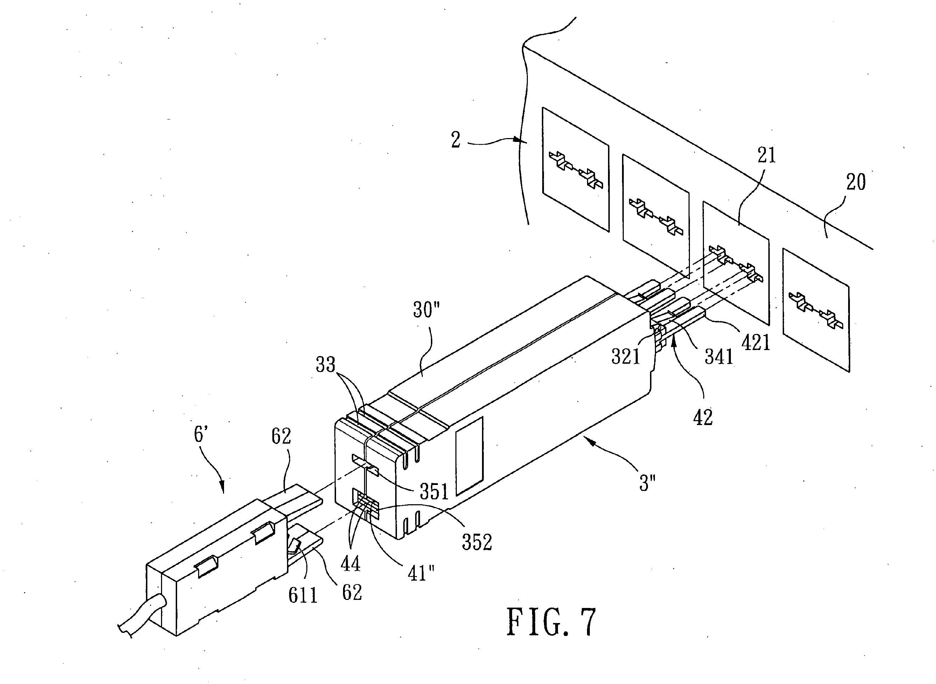

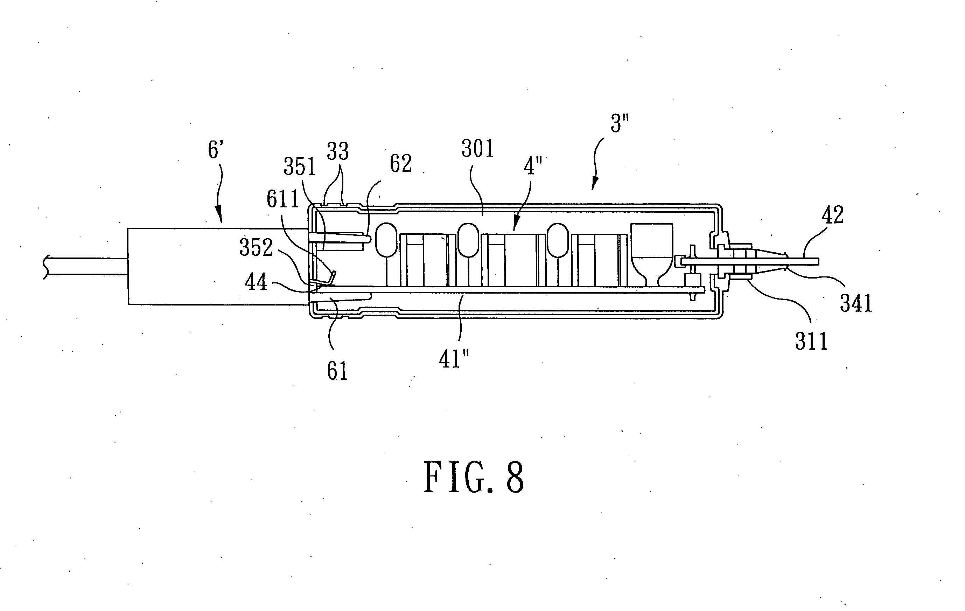

Figures 7 and 8 illustrate the third preferred embodiment of a modular signal splitter 3" according to this invention, which is a modification of the first preferred embodiment. In this embodiment, the circuit portion 41" of the filter circuit 4" is formed with a set of a test pads 44. The casing 30" is formed with a pair of slots 351, 352 adapted for receiving a pair of positioning ribs 62 and a set of metal contacts 611 provided on a test probe 6' of a test equipment such that the metal contacts 611 contact respectively the test pads 44 when the positioning ribs 62 are inserted into and positioned in the slots 351, 352, respectively.

The following are some of the advantages attributed to the modular signal splitter 3, 3' , 3" of the present invention:
1. Due to the presence of the terminal portion 42 of the filter circuit 4, 4', 4" and the fastener unit, the modular signal splitter 3, 3' 3" is easily and securely mounted on the corresponding socket 21 in the switchboard 20 of the telephone exchange 2.
2. Due to the presence of the test pins 43 and the test pads 44, the modular signal splitter 3' , 3" permits direct testing by a test equipment when the modular signal splitter 3' , 3" is mounted on the corresponding socket 21.
3. Since the modular signal splitter 3, 3', 3" is provided for a single subscriber, repairing or replacement thereof does not affect other subscribers coupled to the telephone exchange 2.

## Claims

1. A modular signal splitter (3, 3', 3") adapted to separate a voice signal from a data signal in a telephone exchange (2), the telephone exchange (2) including a switchboard (20) that is provided with a socket (21) coupled to a telephone network, said modular signal splitter (3, 3', 3") being **characterized by**:
a casing (30, 30' , 30") confining a receiving space (301) and formed with a mounting hole (36) therethrough; and
a filter circuit (4, 4' , 4") having a circuit portion (41, 41' , 41") that is disposed in said receiving space (301), anda terminal portion (42) that extends outwardly of said casing (30, 30' , 30") through said mounting hole (36) and that is adapted to be inserted removably into the socket (21) in the switchboard (20) of the telephone exchange (2).

2. The modular signal splitter (3, 3', 3") as claimed in Claim 1, **characterized in that** said casing (30, 30' , 30") includes complementary casing parts (31, 32), each of which is formed with a groove (312, 322), said receiving space (301) being def ined by said grooves (312 , 322) in said casing parts (31, 32).

3. The modular signal splitter (3, 3', 3") as claimed in Claim 2, further **characterized in that** each of said casing parts (31, 32) has a base wall (313, 323), and a surrounding wall (314, 324) that extends from a periphery of said base wall (313, 323), that cooperates with said base wall (313, 323) to define said groove (312, 322), and that is formed with a notch (310, 320), said mounting hole (36) being defined by said notches (310, 320) in said surrounding walls (314, 324) of said casing parts (31, 32).

4. The modular signal splitter (3, 3', 3") as claimed in Claim 3, further **characterized by** a fastener unit (34) for fastening releasably said casing (30, 30' , 30") on the switchboard (20) of the telephone exchange (2) when said terminal portion (42) of said filter circuit (4, 4', 4") is inserted into the socket (21) in the switchboard (20) of the telephone exchange (2).

5. The modular signal splitter (3, 3', 3") as claimed in Claim 4, further **characterized in that** said fastener unit (34) is sleeved through said terminal portion (42) of said filter circuit (4, 4', 4"), and has a securing portion (342) coupled to said casing (30, 30', 30"), and a fastening portion (341) that is opposite to said securing portion (342) and that is formed with a hook (3411).

6. The modular signal splitter (3, 3', 3") as claimed in Claim 5, further **characterized in that** said mounting hole (36) in said casing (30, 30', 30") is defined by ahole-definingwall (315) formed with an engaging recess (3151), said securing portion (342) of said fastener unit (34) being formed with an engaging flange (3421) to engage said engaging recess (3151).

7. The modular signal splitter (3, 3', 3") as claimed in Claim 6, **characterized in that** said mounting hole (36) in said casing (30, 30', 30") is further defined by a peripheral wall (316) formed with support posts (311), said support posts (311, 321) abutting against said fastener unit (34) so as to limit movement of said fastener unit (34) relative to said casing (30, 30', 30") .

8. The modular signal splitter (3') as claimed in Claim 1, **characterized in that** said circuit portion (41') of said filter circuit (4') is provided with a test pin (43), said casing (30') being formed with a slot (35) that is adapted for receiving a test probe (6) of a test equipment to contact said test pin (43).

9. The modular signal splitter (3") as claimed in Claim 1, **characterized in that** said circuit portion (41") of said filter circuit (4") is formed with a test pad (44), said casing (30") being formed with a slot (352) that is adapted for receiving a test probe (6') of a test equipment to contact said test pad (44).
